(19) Europäisches Patentamt
European Patent Office
Office européen des brevets

(11) **EP 3 525 038 A1**

(12) **EUROPEAN PATENT APPLICATION**

(43) Date of publication:
**14.08.2019 Bulletin 2019/33**

(51) Int Cl.:
***G02F 1/1347*** *(2006.01)* ***G09G 3/20*** *(2006.01)*
***G09G 3/00*** *(2006.01)* ***G09G 3/34*** *(2006.01)*

(21) Application number: **18156297.6**

(22) Date of filing: **12.02.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD TN**

(71) Applicant: **Visteon Global Technologies, Inc.
Van Buren Township, MI 48111-5711 (US)**

(72) Inventors:
• **Andreev, Dimitar
  1111 Sofia (BG)**
• **Ivanov, Stoyan Todorov
  1784 Sofia (BG)**
• **Velchev, Marin Vasilev
  1113 Sofia (BG)**

(74) Representative: **MERH-IP Matias Erny Reichl Hoffmann
Patentanwälte PartG mbB
Paul-Heyse-Strasse 29
80336 München (DE)**

(54) **DISPLAY ARRANGEMENT AND METHOD OF CONTROLLING A DISPLAY ARRANGEMENT**

(57) The invention, which relates to a display arrangement (1) and a method for controlling a display arrangement (1), is intended to offer a solution by means of which a more effective, cost-saving and minimally complex protection for a Picture Generating Unit (3), such as a display (3) in a display arrangement (1), from heating caused by incoming sunlight. This problem is solved by the arrangement in that an assembly that permits the regulation of light permeability (13) is arranged on a second side of the display (3) opposite a first side of the display (3). The problem is solved from a method standpoint in that an assembly that permits the regulation of light permeability (13) is provided on a second side of the display (3) opposite a first side of the display (3) which may be switched to be permeable or impermeable to light by means of a second clocked signal, whereby the assembly (13) is switched to be permeable when the backlight (4) is switched-on and switched to be impermeable to light when the backlight (4) is switched-off.

Fig. 1

**Description**

The invention relates to a display arrangement that comprises a display as a Picture Generating Unit and a backlight arranged on a first side of the display.

The invention also relates to a method for controlling a display arrangement, whereby a display is deployed as a Picture Generating Unit with a backlight arranged on a first side of the display, whereby the backlight is switched on or switched off by means of a first clocked signal.

In many technical areas, display arrangements are used to present or display information in a variety of configurations. Examples may include devices and systems such as hi-fi equipment, computers, household appliances or machines, and systems used in production plants. The use of such display arrangements is likewise common in vehicles in order to provide the driver information regarding the driving state of the vehicle such as vehicle speed, engine speed, engine temperature, fuel tank level or additional information regarding assemblies in the vehicle such as the sound system, climate control system or navigation system or other similar systems.

According to the prior art, outfitting a display arrangement or display, as applicable, with a backlight that lights the display included in the display arrangement in order to improve the visibility of the information shown on the display under various lighting conditions is known. For example, the placement of the lighting elements behind or adjacent to image forming surfaces of a LCD displays, short for Liquid Crystal Display, TFT displays, short for Thin-Film Transistor Display, or OLED displays, short for Organic Light Emitting Diode Display is known for such purposes.

The light emitted by the punctual or rod-shaped illumination elements, or light sources, is uniformly distributed across the entire display of the display arrangement by means of appropriate light guides or diffusion screens. This light, uniformly distributed across the surface of the display, illuminates the display from behind in a direction where an observer is located.

In this context, it is known that such lighting elements may be arranged, for example, on one or more end surfaces or such a light guide or a diffusion screen. Alternatively, such lighting elements may be arranged in the form of a matrix, i.e. in multiple rows with multiple columns, behind the image forming surfaces of a display arrangement.

In addition, controlling the intensity of a backlight by means of a pulse-width modulated signal, i.e. by means of pulse width modulation ("PWM"), is known.

Based on the state of the art, projecting information to the field of view of a user, for example a person controlling a vehicle such as a driver or pilot, via a heads-up display, is likewise known. A heads-up display ("HUD") is to be understood as a display system whereby the user may maintain the position of her head, or the direction of view in essentially the original direction, in order to view information. Such heads-up displays generally comprise a Picture Generating Unit ("PGU"), which supplies the information to be displayed in the form of an image, an optics module with mirrors which permits the beam path to run within the heads-up display to an outlet opening and is also described as a mirror optics, as well as a projection surface for generating the image or the contents to be displayed. In some embodiments of such heads-up displays, the Picture Generating Unit comprises an LCD display, a TFT display or a combination of both technologies (TFT-LCD).

In a heads-up display, the optics module directs the image created by the Picture Generating Unit, i.e. a display within the display arrangement, on the projection surface which comprises a reflecting, transparent screen and is also described as a combiner. The driver of the vehicle sees the mirrored information from the Picture Generating Unit in the form of a virtual image and at the same time is able to see the real environment behind the windshield. Accordingly, the attention of the person controlling the vehicle, for example a person driving a car, remains on what is happening in front of the vehicle whereby she is able to view the information projected on the field of view. In some use cases, the windshield of a vehicle is used as the projection surface.

Information that may be displayed using such a display arrangement, for example a heads-up display, includes information on operating status, such as information about vehicle speed, engine speed, payload, equipment, as well as information from the navigation system, radar system or targeting system. Furthermore, to use vehicles as an example, information regarding currently applicable route restrictions such as no passing zones and speed limits, or the current setting of adaptive speed regulators (adaptive cruise control - "ACC") or other information could be displayed.

The backlight needed in order to illuminate such as display represents a first heat source in a display arrangement which results in undesired heating of the display. These types of display arrangements may also be subject to other heat sources such as incoming sunlight. Incoming sunlight may also result in additional heating of the display in a display arrangement. Such heating may, in particular if a critical temperature is exceeded, result in partial or complete malfunction of the display. Such a heat-related malfunction of the display must be prevented.

Sunshine is a critical factor for a display especially when the display is used as a heads-up display that is primarily arranged in a portion of the windshield a vehicle. For purposes of projecting the information to be displayed, an image is created in the Picture Generating Unit from which the image reaches the windshield via the mirrored optics module and thus is displayed to the driver in the form of a virtual image. For this purpose, an opening is included for the heads-up display in an area below the windshield, in the dashboard for example, through which the created image may exit in order to be displayed on the windshield.

As a result of this opening it is possible for incoming sunshine to reach the opening as well as the optics module with the mirrors to the surface of the display in the display arrangement, such as a TFT display, by means of a reversal of the beam path for the virtual image through the windshield and to heat it further. Accordingly, measures must be taken in order to avoid heat-related damage to the Picture Generating Unit, in particular the display within the display arrangement. For example, damage to the layer of a display containing liquid crystals needs to be prevented.

Based on the known state of the art, there are various methods for protecting display, for example a TFT display, from incoming sunlight and thus reduce additional heating of the display.

A first option is to use so-called polarized glass in front of the display from the display arrangement in order to block a portion of the sunlight so that at least a certain portion of the sunlight does not reach the surface of the display and thus cannot contribute to heating of the display.

A system and method for sensing the temperature of a TFT display as well as reducing the temperature above a threshold value is known from US 2015 0294644 A1. The method comprises setting a backlight to a switched-off state in order to reduce the heating influence of the backlight whereby the temperature of the display unit declines rapidly. Multiple sensors arranged in the form of a matrix are provided for purposes of determining the temperature of a TFT display. A sensor signal generated by the sensors is evaluated in a special control switch using a threshold value and thus reaching or exceeding a maximum permitted threshold value in the TFT display is thus detected. In such cases, the control switch turns of the backlight. The sensors arrange in a matrix comprise capacitive sensors.

In JP 2015 152732 A, the use of so-called polarizing plates is disclosed in order to polarize sunlight and to create a heat sink for a heads-up display arrangement. The heads-up display arrangement comprises a backlight and a liquid crystal display element which is arranged transversely to a liquid crystal layer via a first polarizing plate that is arranged on the side of backlight and includes a polarizing plate that is arranged opposite the first polarizing plate. This display surface of the liquid crystal display element is primarily arranged in parallel to a light emitting surface of the backlight. In addition, a further polarizing plate is provided for which is arranged so as to tilt toward the liquid crystal display element. In addition, it is disclosed that a liquid crystal layer is included in the liquid crystal display element between a TFT substrate and a CF substrate that, upon application of an electric field, changes optical properties as a result of the alignment of the liquid crystal molecules. The VA Mode, short for Vertical Alignment Mode, is used for example as a liquid crystal mode. Furthermore, the TN Mode, short from Twisted Nematic Mode, is disclosed as a homogeneous mode.

A heads-up display ("HUD") device, and a method, capable of effectively preventing damage to a liquid-crystal display device due to entry of exterior light is known from US 2015 0098029 A1.
The HUD device is provided with an infrared-ray sensor positioned behind the flat mirror. A control means reduces the brightness of the light of the backlight or extinguishes the backlight when the strength detected by the infrared-ray sensor exceeds a predetermined threshold. The liquid crystal display panel comprises a liquid crystal panel such as twisted nematic type, vertical alignment type, super-twisted nematic type or a ferroelectrics type. The liquid crystal display panel can be a TFT display or a segment display.
The polarizing plates are arranged so that transmission axis to be orthogonal, i.e. a crossed nicols prism, or parallel to each other, i.e. a paralleled nicols prism.

US 2012 0176569 A1 relates to a liquid crystal panel corresponding to a so-called double cell super twisted nematic type liquid crystal panel with a polarizing plate on a matrix surface. As a result, a device is disclosed whereby polarizing plates are arranged on a surface of a liquid crystal panel.

The solutions know from the state of the art are, to some extent, technically difficult to implement and, in some cases, require multiple sensors as well as a corresponding control mechanism in order to recognise when conditions are critical for the display or the Picture Generating Unit of a display arrangement as applicable. Furthermore, in the case of methods that reduce the brightness of the backlight of the display partially or fully, the visibility of the information shown on the display and/or the virtual image is impaired.

Accordingly, there is a need for an improved solution for protecting a Picture Generating Unit within a display arrangement.

The object of the invention is thus to provide a display arrangement and a method for controlling a display arrangement by means of which a more effective, cost-saving and minimally complex protection for a Picture Generating Unit, such as a display in a display arrangement, from heating caused by incoming sunlight.

The objective is achieved by means of a display arrangement with the characteristics according to patent claim 1 of the independent patent claims. Further embodiments are described in the dependent patent claims 2 to 5.

The objective is also achieved by means of a method with the characteristics according to patent claim 6 of the independent patent claims. Further embodiments are described in the dependent patent claims 7 to 10.

In particular, the invention is intended to prevent damage to a Picture Generating Unit in a display arrangement such as a TFT display. This applies in particular for cases in which the Picture Generating Unit is used to provide a virtual image on the windshield of a vehicle in a heads-up display and/or a heads-up display arrangement.

To that end, an assembly that permits the regulation of light permeability, is to be arranged on the first side of the Picture Generating Unit which faces the exterior light or sunlight, also known as the front. In particular, the intent is to influence and/or dampen the wavelength range of the sunlight in the assembly that permits the regulation of light permeability which results in heating of the Picture Generating Unit. As a result of this influence, or dampening, the sunlight is prevented from penetrating the assembly that permits the regulation of light permeability. In such cases, the sunlight cannot reach the Picture Generating Unit that is aligned in the direction of the incoming sunlight behind the assembly that permits the regulation of light permeability and thus not provide heat or additional warmth.

An assembly that permits the regulation of light permeability is preferred as a liquid crystal display element made of so-called Schadt-Helfrich cells which are also described as nematic twisted cells, or in English "twisted nematic" ("TN cells"). The assembly may be designed in the form of a flat plate or disk and is referred to hereinafter as a "Twisted Nematic Shield" or "TNS".

In the case of the TNS technology, an effect is used by which polarized light that passes through liquid crystal molecule of a liquid crystal cell that is turned in the direction of the polarization. When an electrical field is applied to the liquid crystal cell, the liquid crystal molecules arrange themselves in parallel to each other, whereby the rotation of the polarisation direction stops. In that case, light cannot pass through the liquid crystal cell.

The TNS thus becomes non-permeable or permeable for both the light of the display arrangement as well as for incoming sunlight by means of switching-on or switching-off attached electrical current. In this context, the TNS for example is permeable for the light of the display arrangement as well as for incoming sunlight if the current is turned-off and becomes permeable for the light of the display arrangement as well as for incoming sunlight when the current is turned on.

The light intensity of the backlight of the Picture Generating Unit of the display arrangement may be adjusted. The light intensity may be controlled by means of a first clocked signal that may be adjusted as to pulse width as well as pulse breadth or duration, for example by means of pulse width modulation ("PWM"). A first clocked signal in the form of a PWM signal may be created on a control board of the display arrangement in order to control the backlight.

The first clocked signal, also referred to as a PWM signal, may be used preferably to control the backlight in order to generate a second clocked signal. The second clocked signal, which is also referred to hereinafter as a control signal, serves to control the assembly that permits the regulation of light permeability, i.e. for example the Twisted Nematic Shield or "TNS",

In this context, the PWM signal generated for purposes of controlling the backlight may be used in its negative form as a control signal to control the assembly that permits the regulation of light permeability.

The use of the existing PWM signal in accordance with the invention results, first, in a sharp reduction in the complexity needed to create the control signal for the assembly that permits the regulation of light permeability, i.e. a TNS, and second likewise ensures the concurrent, synchronous control of the backlight and the TNS given that the switching edges of the signals may be easily synchronized. In a special embodiment, the PWM signal need only to be negated for the assembly that permits the regulation of light permeability in order to provide a control signal.

In the event that the PWM signal evidences a certain level, for example a low level, where the backlight is not controlled and switched-off, it is provided that the Twisted Nematic Shield, i.e. "TNS", is controlled with a negated level of the PWM signal, i.e. a high level, and thus becomes non-permeable to light. In such cases, the sunlight penetrating the windshield may not reach the display arrangement given that the display is arranged in the direction of the incoming sunlight behind the TNS on the second side of the display. As a result, the display is not additionally heated by the incoming sunlight and is thus protected.

In the case that the PWM signal evidences a certain level, for example a high level, it is provided that the backlight will be controlled and switched-on. As a result, the TNS is controlled with a negated level of the PWM signal, i.e. a low level, and is thus permeable to light. The image, for example one generated via TFT display, can be transmitted in a display arrangement such as a heads-up display with mirrors by means of the optics module and reach the combiner or windshield as applicable. The virtual image generated for the driver may thus be presented in his field of view along with the corresponding information.

The PWM signal may, for example, be provided such that a so-called duty cycle of a rectangular pulse underlying the signal generation has a value of 0.25 or 25%. Such a duty cycle describes the relationship of the pulse length $t_i$ of the rectangular pulse, i.e. the time in which the PWM signal has a high level to its pulse duration T:

$$\text{Duty cycle} = t_i\ /\ T.$$

A duty cycle of 0.25 or 25% means that the backlight for 25% of the cycle time T of the rectangular pulse is switched-on and is switched-off for 75% of the cycle time T of the rectangular pulse. By means of negating the PWM signal for the assembly that permits the regulation of light permeability, such as the Twisted Nematic Shield, the assembly is switched-on for 75% of the cycle time T of the rectangular pulse and is thus opaque, or impermeable to light, and for incoming sunlight as well and is switched-on for 25% of the cycle time T of the rectangular pulse and is thus permeable to light in order to enable the projection of the virtual image for the driver.

If increased intensity is required in the display arrangement in order to display the virtual image, the duty cycle may be increased and, for example, a value of 0.5 or 50% or 0.75 or 75% may be used or other values as needed.

In the case of a duty cycle of 0.75 or 75%, the backlight is switched-on for 75% of the cycle time T of the rectangular pulse and is switched-off for 25% of the cycle time T of the rectangular pulse.

In such cases, the assembly that permits the regulation of light permeability is switched-on for 25% of the cycle time T of the rectangular pulse, and thus not permeable to light, and is switched-off for 75% of the cycle time T of the rectangular pulse and is thus permeable to light.

In accordance with the examples, the assembly that permits the regulation of light permeability is impermeable to light at least 25% or more than 25% of the cycle time T of the rectangular pulse and protects the display in the display arrangement from incoming sunlight.

In addition, providing a control signal as a differential signal is intended for the assembly that permits the regulation of light permeability. In this case as well, the required differential signal will also be derived from the PWM signal to the control backlight and thus provided to it synchronously.

Additional details and benefits of embodiments of the invention may be found in the following description of sample embodiments with reference to the drawings associated therewith. They show:

Fig. 1: A schematic diagram of a display arrangement according to the invention as a heads-up display arrangement in a vehicle;

Fig. 2: An embodiment of an assembly that permits the regulation of light permeability;

Fig. 3: A voltage-against-time run of a PWM signal for controlling the backlight with a duty cycle of 75% and 50% in a display arrangement based on the state of the art;

Fig. 4: A voltage-against-time run of a PWM signal for controlling the backlight with a duty cycle of 25% in a schematic diagram to highlight how the invention works;

Fig. 5: A depiction of a liquid-crystal display element with twisted nematic cells ("TN cells") based on the state of the art;

Fig. 6: A depiction of a control signal derived from a PWM signal to control the assembly that permits the regulation of light permeability such as a Twisted Nematic Shield ("TNS"); and

Fig. 7: A voltage-against-time run of a differential signal to control the assembly that permits the regulation of light permeability such as a Twisted Nematic Shield ("TNS").

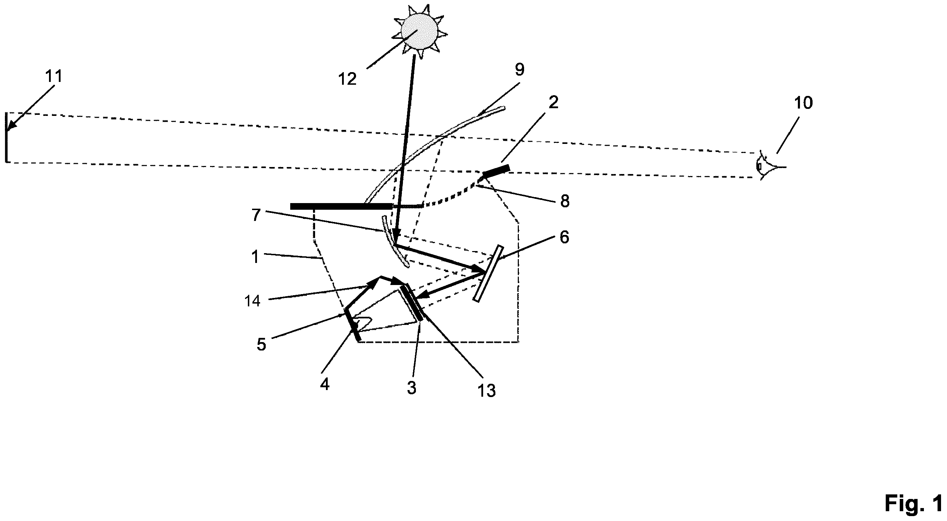

**Fig. 1** depicts a schematic diagram of a display arrangement according to the invention 1 as a heads-up display arrangement 1 in a vehicle. The application of the subject invention, as a display arrangement 1 in a vehicle, for example in a dashboard or centre console of a vehicle, is similarly conceivable even if the application of the invention in a heads-up display arrangement 1 is especially effective.

The example of a heads-up display arrangement 1 below a dashboard 2 in a vehicle comprises at least one display 3, a backlight 4 arranged on a first side of the display 3, a control unit 5, an optics module comprising a first mirror 6 and a second mirror 7 as well as a cover glass 8 which is arranged in an opening in the dashboard 2 below the windshield 9.

A standard heads-up display arrangement 1 is used to generate a virtual image 11 to be projected for a driver 10, whereby an image and/or information is provided for projection of the virtual image 11 on the display 3, for example a TFT display 3. For purposes of projecting the virtual image 11, the backlight 4 is switched-on by means of a clocked signal, whereas the backlight 4 is switched-off by means of a first clocked signal during periods in which no projection is to be displayed.

The generation of the information to be displayed on the display 3, control of the backlight 4 of the display 3 as well as additional required processes in the heads-up display arrangement 1 are controlled by the central control unit 5. The central control unit 5 may provide such a first clocked signal, for example in the form of a PWM signal 15, which is presumed below for purposes of simplifying the description.

As depicted in Fig. 1 with the arrow emanating from the sun 12, sunlight passing through the windshield 9 from the sun 12 may penetrate the cover glass 8 and reach the display 3 deflected via the second mirror 7 and the first mirror 6. The incoming sunlight results in additional heating for the display 3 of the display arrangement 1 and, in the case that a maximum permitted temperature of the display 3 is reached or exceeded, to partial or complete impairment of the proper function of the display 3. In the case of a TFT display for example, the maximum permitted temperature may be around 95°C.

Even if there are numerous different solutions for a heads-up display based on the state of the art, which for example may differ materially based on the type of display used, the combiner or optics module, they nonetheless exhibit the common element that incoming sunlight results in heating within the heads-up display arrangement 1 and in particular the display 3.

According to the invention, the sunlight is prevented from reaching the display 3 in part thus preventing the maximum permitted temperature for the display 3 from being exceeded. An assembly that permits the regulation of light permeability 13 is arranged on the second side of the display 3 in the direction of the incoming sunlight in front of the display 3 for this purpose. The assembly 13 if may for example comprise a panel or square plate and is arranged in parallel to the surface of the display 3. The dimensions of the assembly 13 preferably correspond to the dimensions of the display 3. In this case, it is possible to arrange the display 13 spaced apart or directly on the surface of the display 3. A connection between the assembly 13 and the display 3, for example in the form of an optical bond or similar process and/or adhesion process, is intended.

The assembly that permits the regulation of light permeability 13 may, for example, comprise a Twisted Nematic Shield or "TNS". A TFT display 3 may be used for example as the display 3.

The assembly that permits the regulation of light permeability 13 is controlled by a second clocked signal and may be made permeable or impermeable to light via this signal, whereby the second clocked signal makes the assembly 13 permeable or impermeable to light.

One embodiment provides that the second clocked signal is derived from a PWM signal and is introduced to the switching edges as a control signal 14 synchronous to the PWM signal. It is intended that both the PWM signal for controlling the backlight 4 as well as the control signal 14 for the assembly 13 are provided by the control unit 5. In Fig. 1, the control signal 14 is depicted by arrows each of which comprise a dashed line. The control signal 14 causes, on the one hand, the assembly 13 to become permeable to light in the event that a virtual image 11 is to be projected for the driver 10. The control signal 14 causes, on the other hand, the assembly 13 to become impermeable to light in the event that no virtual image 11 is to be generated. The impermeable state of the assembly 13 prevents the incoming sunlight from reaching the surface of the display 3 and causes it to heat.

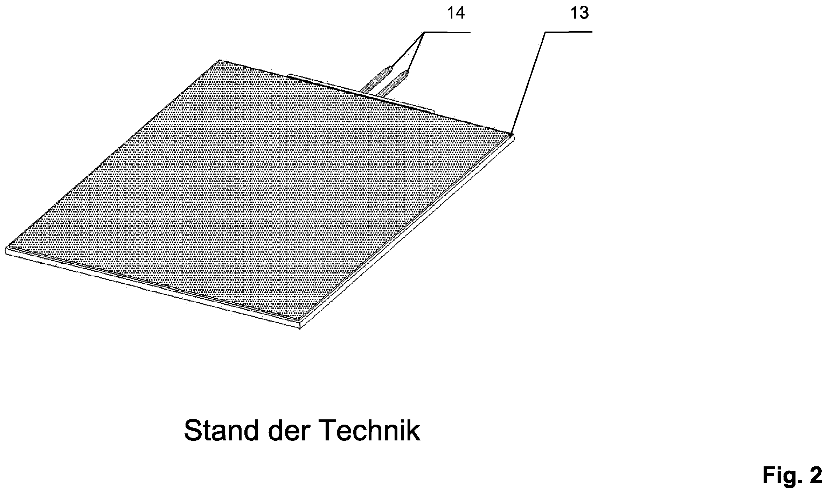

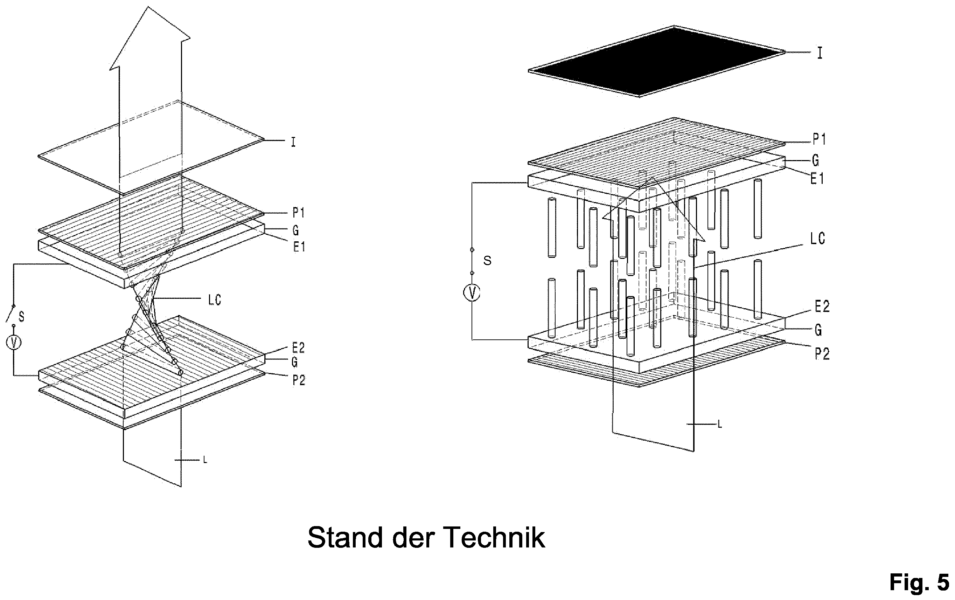

Fig. 2 depicts an assembly that permits the regulation of light permeability 13 which comprises the form of a square plate or disk. The dimensions of the assembly 13 are adapted to the dimensions of the display 3 not depicted in Fig. 2. Accordingly, it is possible to completely prevent incoming sunlight from reaching the display 3 in the event that the display 13 has assumed its impermeable state. The assembly that permits the regulation of light permeability 13 comprises, for example, a liquid crystal display element with twisted nematic ("TN") cells. The functionality of such an assembly 13 the TN cells is depicted in more detail in Fig. 5. In principle, the assembly 13 may assume a state that is permeable or impermeable to light in dependence on the control signal 14 attached to the two connections depicted. Whereas during times in which the virtual image 11 is projected in the permeable state, sunlight from the sunlight 12 cannot reach the surface of the display 3 of the display arrangement 1 in its impermeable state.

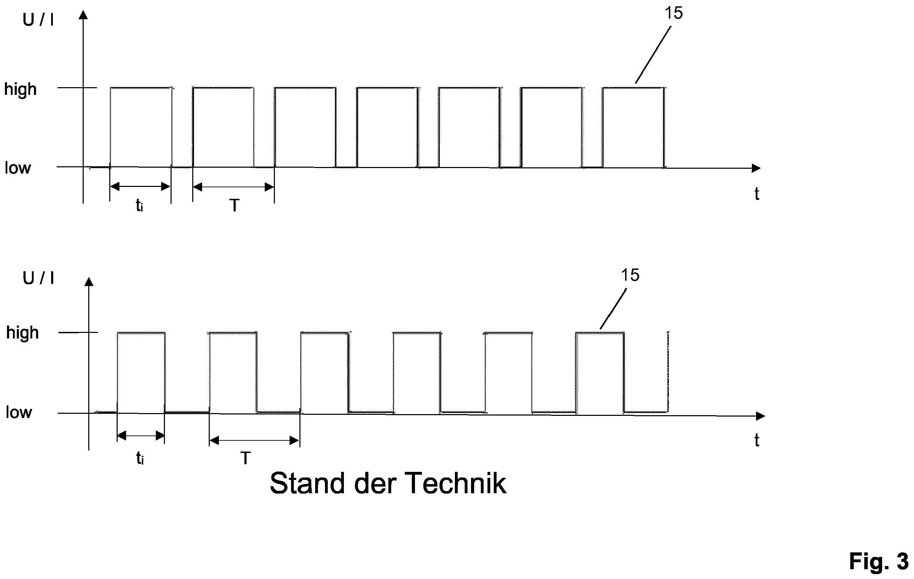

Fig. 3 depicts two voltage-against-time runs for PWM signals 15 for controlling the backlight 4 of the display arrangement 1. A current-against-time run could also be displayed in lieu of a voltage-against-time run. A so-called duty cycle of such a PWM signal 15 is determines the relationship of the pulse length $t_i$ of the rectangular pulse, i.e. the time in which the PWM signal 15 has a high level to its pulse duration T for example:

$$\text{Duty cycle} = t_i \,/\, T.$$

The depiction above from Fig. 3 shows, for example, a PWM signal 15 for controlling the backlight 4 with a duty cycle of 0.75 or 75%. The depiction below from Fig. 3 shows a duty cycle of 0.5 or 50%. A longer on-period for the backlight 4 and thus a larger pulse length $t_i$ of the rectangular pulse causes greater intensity in the backlight 4 of the display arrangement 1 according to the state of the art. In order to protect the display 3 from incoming sunlight, the assembly that permits the regulation of light permeability 13 is made impermeable for periods that are not filled by the impulse length ti. This is possible given that the backlight 4 of the display arrangement 1 is not switched-on during such periods and thus no virtual image 11 is projected for the driver 10.

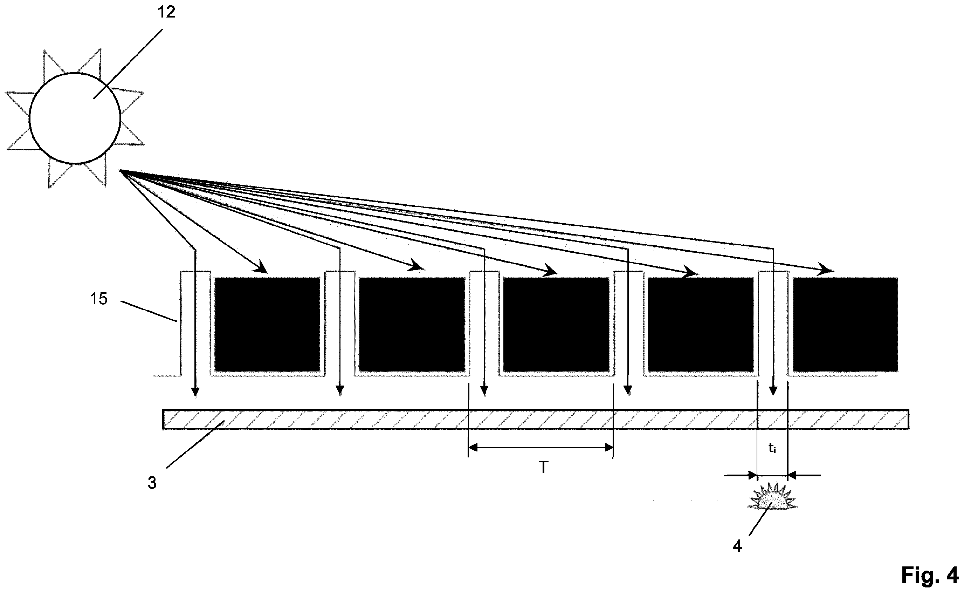

Fig. 4 depicts a voltage-against-time run of a PWM signal 15 for controlling the backlight 4 with a duty cycle of 0.25 or 25% in a schematic diagram to highlight how the invention works. A display 3, for example a TFT display, is shown below the depicted PWM signal 15. The sun 12 is depicted above the PWM signal 15. Without the application of the solution according to the invention the rays from the sun 12 would reach the display 3 and could thus cause additional heating.

In order to project a virtual image 11 for the driver 10, the backlight 4, depicted symbolically as a light source below the display 3, is switched-on for the duration of the respective pulse length $t_i$ of the rectangular pulse. The virtual image 11 is generated for the duration $t_i$ and the display 3 may be reached by the incoming sunlight. This process is symbolically represented by the five arrows that are marked within pulse length $t_i$ of the rectangular pulse and reach the surface of the display 3.

A control signal 14 to control the assembly that permits the regulation of light permeability 13 is provided by negating the PWM signal 15. The control signal 14 controls the assembly 13 such that it is permeable during the pulse length $t_i$ of the rectangular pulse and assumes its impermeable state for the remaining time. The impermeable state of the assembly 13 is depicted by the black square surfaces in Fig. 4. The sunlight may not reach the display 3 to a degree of 75% based on the depicted duty cycle of 0.75 or 75%. Accordingly, heating of the display 3 by incoming sunlight is reduced dependent upon the current duty cycle.

Furthermore, the display 3 may be 100% protected by turning off the vehicle in the park position for example. This makes is possible to forego a complex and expensive mechanism for closing a mirror or closing the opening to the cover glass 8.

**Fig. 5** depicts a liquid-crystal display element with twisted nematic cells ("TN cells") based on the state of the art.

The Twisted Nematic effect used in the assembly that permits the regulation of light permeability included in the invention is based on precisely controlled realignment of liquid crystal molecules between variously ordered molecule configurations subject to the application of an applied electrical field. This is achieved with low electricity consumption and low operating voltages.

Fig. 5 shows two exploded views of a Twisted Nematic liquid crystal cell or "TN cell". In left portion of Fig. 5, the TN cell is depicted in light permeable state without an applied external voltage whereas the TN cell in the right part of Fig 5 is depicted in an impermeable state with applied external voltage.

In a so-called OUT state, i.e. when no electrical field is being applied, a twisted configuration of nematic liquid crystal molecules "LC" - also described as a helix - is created between two glass panels G that are separated from each other by means of several spacers. The glass panels G each include an associated transparent electrode E1, E2. The electrodes E1, E2 are coated with a so-called alignment layers that rotate the liquid crystal precisely by 90° if there no external electrical field.

If a light source with the corresponding polarization shines on the front side of the TN cell depicted below, the light L will enter the TN cell via a first polarizer P2 where it is twisted by means of the helix structure. The light L is then polarized so as to pass through the second polarizer P1 which is opposite the first polarizer P2 and rotated by 90°. The light L then passes through the back of the TN cell as shown in the left part of the depiction in Fig. 5. The TN cell appears in level I transparent or permeable to light.

When an external electric current S is applied to such a TN cell, as shown in the depiction on the right in Fig. 5, the helix structure of the nematic liquid crystal molecule LC is dissolved by the electrical created between the transparent electrodes E1, E2 in that the liquid crystal molecules LC are aligned based on the field. In such cases, the light L can enter the TN cells on the front via the depicted TN cell via the first polarizer P2, however is not rotated by the helix structure and can thus not pass through the second polarizer P1. The TN cell appears in level I dark or impermeable to light.

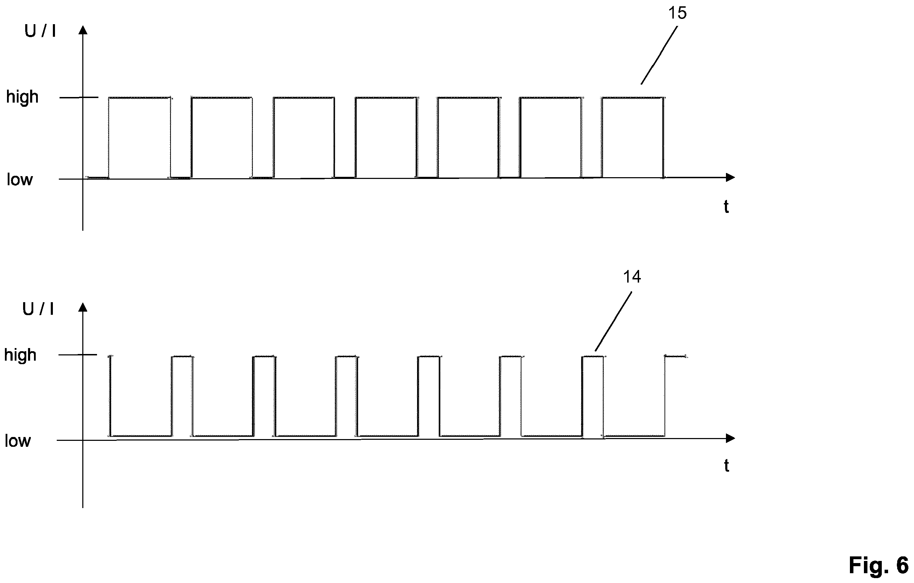

**Fig. 6** shows a depiction of a control signal 14 derived from a PWM signal 15 to control the assembly that permits the regulation of light permeability 13, such as a TNS. A current-against-time run and/or voltage-against-time run of a PWM signal 15 is shown in the upper part of Fig. 6.

Given that the virtual image 11 is to be generated with a switched-on backlight 4, i.e. in periods in which the PWM signal 15 has a high level, the assembly that permits the regulation of light permeability 13 must be switched to permeable during such times. In order to do so, no current or low-level current is applied to the assembly 13 at certain times. No virtual image 11 is generated during periods in which the PWM signal 15 has a low level. As a result, the assembly 13 may be switched to impermeable during these periods by applying a high-level current to the assembly 13. The control signal 14 resulting from these requirements for the assembly that permits the regulation of light permeability 13 is depicted in the lower diagram in Fig. 5. One possibility of generating this control signal 14 synchronous with the PWM signal 15 comprises the negation of the PWM signal 15.

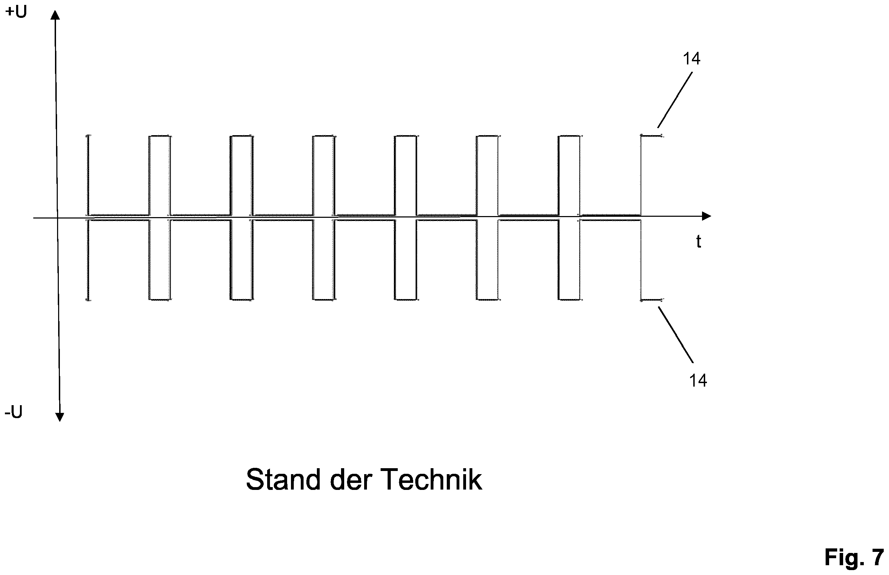

**Fig. 7** depicts a voltage-against-time run of a control signal 14 in the form of a differential signal to control the assembly that permits the regulation of light permeability 13, such as a TNS.

Above the time axis, Fig. 7 shows the control signal 14 known from Fig. 6 for controlling the assembly that permits the regulation of light permeability 13. The control signal 14 may also be provided in the form of a known differential signal for purposes of controlling a TNS 13 as shown in Fig. 7.

The advantages of the display arrangement 1 shown here as well as the method for controlling the display arrangement 1 lie in the fact that the amount of sunlight that absorbed by the display 3 in the display arrangement 1 is reduced between 30% and 50%. This protects the display 3 from excessive heat and damage.

If the vehicle, for example a motor vehicle or automobile, is parked the display arrangement based on the state of the art is often in a so-called parked position. This means that one of the mirrors of such a display arrangement, for example, must be folded down in order to avoid undesired sunlight. This action requires a movably mounted mirror as well as a corresponding mechanical assembly in order to effect the folding of the mirror. This requires larger installation space and increased costs for such a display arrangement based on the state of the art.

Space requirements and thus the costs for such a display arrangement 1 are lower based on the use of a display arrangement 1 and the method for controlling a display arrangement 1 given that this complexity is no longer needed.

**Reference numeral index**

1    Display arrangement / Heads-up display arrangement
2    Dashboard
3    Display (TFT display) / Picture Generating Unit
4    Backlight
5    Control unit
6    First mirror
7    Second mirror
8    Cover glass

| 9 | Windshield |
|---|---|
| 10 | Driver |
| 11 | Virtual image |
| 12 | Sun |
| 13 | Assembly that permits the regulation of light permeability / TNS |
| 14 | Control signal / Second clocked signal |
| 15 | PWM signal / First clocked signal |

| E1, E2 | Electrode |
|---|---|
| G | Glass panel |
| I | Level |
| L | Light |
| LC | Liquid crystal molecule |
| P1, P2 | Polarizer |
| S | Electrical voltage |

**Claims**

1. Display arrangement (1) which comprises a display (3) as a Picture Generating Unit and a backlight (4) arranged on a first side of the display (3), **characterised in that** an assembly that permits the regulation of light permeability (13) is arranged on a second side of the display (3) that is opposite a first side of the display (3).

2. Display arrangement (1) according to claim 1, **characterised in that** the dimensions of the assembly that permits the regulation of light permeability (13) correspond to the dimensions of the display (3).

3. Display arrangement (1) according to claim 1 or 2, **characterised in that** the assembly that permits the regulation of light permeability (13) comprises a Twisted Nematic Shield ("TNS).

4. Display arrangement (1) according to one of claims 1 to 3, **characterised in that** the assembly that permits the regulation of light permeability (13) is arranged parallel to the surface of the second side of the display (3) and either spaced apart from it or adhesively bonded to the surface.

5. Display arrangement (1) according to one of claims 1 to 4, **characterised in that** the display arrangement (1) comprises a heads-up display arrangement (1) and/or that the display (3) comprises a TFT display.

6. Method for controlling a display arrangement (1) whereby a display (3) is provided as a Picture Generating Unit with a backlight (4) arranged on a first side of the display (3), whereby the backlight (4) is switched-on and switched-off by means of a clocked signal, **characterised in that** an assembly that permits the regulation of light permeability (13), that may be made permeable and impermeable to light by means of a clocked signal, is arranged on a second side of the display (3) opposite the first side of the display (3), whereby assembly (13) is switched to permeable when the backlight (4) is switched-on and switched to impermeable when the backlight (4) is switched-off.

7. Method according to claim 6 **characterised in that** the first clocked signal is a PWM signal (15).

8. Method according to claim 6 or 7 **characterised in that** the second clocked signal is a control signal (14) that is generated synchronously in its switching edges to the first clocked signal.

9. Method according to one of claims 6 to 8 **characterised in that** the control signal (14) is generated by means of negating the first clocked signal, in particular the PWM signal (15).

10. Method according to one of claims 6 to 9 **characterised in that** the PWM signal (15) has a duty cycle between 0.1 and 0.9, in particular between 0.25 and 0.75.

**Fig. 1**

Stand der Technik

Fig. 2

EP 3 525 038 A1

Stand der Technik

**Fig. 3**

Fig. 4

Fig. 5

Stand der Technik

**Fig. 6**

U / I
high
low
t

15

U / I
high
low
t

14

Stand der Technik

Fig. 7

Europäisches
Patentamt

European
Patent Office

Office européen
des brevets

## EUROPEAN SEARCH REPORT

Application Number

EP 18 15 6297

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/184894 A1 (HAYASHI SHINGO [JP] ET AL) 29 June 2017 (2017-06-29) | 1,2 | INV.<br>G02F1/1347 |
| Y | * abstract *<br>* paragraphs [0003], [0010] - [0011], [0032] - [0051]; figures 1-3 *<br>----- | 3-10 | G09G3/20<br>G09G3/00<br>G09G3/34 |
| Y | US 6 646 696 B1 (WALSH KEVIN L [US]) 11 November 2003 (2003-11-11)<br>* abstract *<br>* column 2, line 1 - column 4, line 67; figures 1-3 *<br>----- | 3,5 | |
| Y | US 2009/109351 A1 (SHIOMI MAKOTO [JP]) 30 April 2009 (2009-04-30)<br>* paragraph [0135] *<br>----- | 4 | |
| A | JP 2006 209003 A (RICOH KK) 10 August 2006 (2006-08-10)<br>* abstract *<br>----- | 1-10 | |
| Y | US 2006/164377 A1 (STRUEBEL MARK A [US] ET AL) 27 July 2006 (2006-07-27)<br>* abstract *<br>* paragraph [0013] - paragraph [0019]; figures 1-2 *<br>----- | 6-10 | TECHNICAL FIELDS<br>SEARCHED (IPC)<br><br>G02F<br>G09G<br>G02B<br>B60R<br>B60K |
| X | US 2011/273659 A1 (SOBECKI JUSTIN E [US]) 10 November 2011 (2011-11-10) | 1-5 | |
| Y | * abstract *<br>* paragraphs [0002] - [0006], [0016] - [0023], [0028] - [0032]; figures 1-6 *<br>----- | 6-10 | |

The present search report has been drawn up for all claims

| Place of search | Date of completion of the search | Examiner |
|---|---|---|
| Munich | 13 April 2018 | Wolff, Lilian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 18 15 6297

This annex lists the patent family members relating to the patent documents cited in the above-mentioned European search report.
The members are as contained in the European Patent Office EDP file on
The European Patent Office is in no way liable for these particulars which are merely given for the purpose of information.

13-04-2018

| Patent document cited in search report | | Publication date | Patent family member(s) | | Publication date |
|---|---|---|---|---|---|
| US 2017184894 | A1 | 29-06-2017 | CN<br>JP<br>US | 106918963 A<br>2017120311 A<br>2017184894 A1 | 04-07-2017<br>06-07-2017<br>29-06-2017 |
| US 6646696 | B1 | 11-11-2003 | NONE | | |
| US 2009109351 | A1 | 30-04-2009 | CN<br>JP<br>JP<br>US<br>WO | 101405649 A<br>4870151 B2<br>WO2007108183 A1<br>2009109351 A1<br>2007108183 A1 | 08-04-2009<br>08-02-2012<br>06-08-2009<br>30-04-2009<br>27-09-2007 |
| JP 2006209003 | A | 10-08-2006 | JP<br>JP | 4533169 B2<br>2006209003 A | 01-09-2010<br>10-08-2006 |
| US 2006164377 | A1 | 27-07-2006 | EP<br>US<br>WO | 1842181 A1<br>2006164377 A1<br>2006081036 A1 | 10-10-2007<br>27-07-2006<br>03-08-2006 |
| US 2011273659 | A1 | 10-11-2011 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20150294644 A1
- JP 2015152732 A
- US 20150098029 A1
- US 20120176569 A1